# EUROPÄISCHE PATENTANMELDUNG

(11) **EP 0 583 678 A2**
(43) Veröffentlichungstag der Anmeldung: **23.02.1994**
(21) Anmeldenummer: 93112428.3
(22) Anmeldetag: 03.08.1993
(51) Int. Cl.: G03F 7/00, G03F 7/20, G03F 7/40

(54) **Verfahren zur Erzeugung einer reliefartigen Oberflächenstruktur und Anwendungen des Verfahrens**

(30) Priorität: 14.08.1992 DE 4227044
(71) Anmelder: SIEMENS AKTIENGESELLSCHAFT, D-80333 München (DE)
(72) Erfinder: Stoll, Lothar, Dipl.-Phys., D-81369 München (DE)

(57) **Zusammenfassung**

2.1 Es soll ein besonders einfaches Verfahren der genannten Art angegeben werden, mit dem beliebige reliefartige Oberflächenstrukturen kontrolliert und gut reproduzierbar hergestellt werden können.

2.2 Dazu wird auf der Oberfläche des Substrats eine Photolackschicht mit einer reliefartigen Oberflächenstruktur, die im wesentlichen gleich der zu erzeugenden reliefartigen Oberflächenstruktur auf der Oberfläche des Substrat ist, erzeugt, und mit einem Abtragverfahren, das sowohl den Photolack als auch vom Photolack freies und/oder freiwerdendes Substratmaterial abträgt, der Photolack entfernt.

2.3 Anwendung überall dort, wo mikroskopisch reliefartig strukturierte Oberflächenstrukturen angewendet werden, wie in der Optik oder Mikromechanik.

## Beschreibung

Die Erfindung betrifft gemäß dem Oberbegriff des Patentanspruchs 1 ein verfahren zur Erzeugung einer reliefartigen Oberflächenstruktur auf der Oberfläche eines Substrats.

In vielen technischen Bereichen werden mikroskopisch reliefartig, d.h. dreidimensional strukturierte Oberflächenstrukturen angewendet, z.B. in der integrierten Optik beispielsweise in Form von optischen Schichtdicken-Tapern bei optischen Wellenleitern, geodätischen Linsen oder integrierten Mikrolinsen, bei optischen Interconnects beispielsweise in Form von Fresnel-Linsen, in der integrierten Optoelektronik beispielsweise in Form flacher Übergänge für optische Wellenleiter zwischen Strukturebenen, in der optischen Gittertechnik beispielsweise in der Form von Blaze-Gittern, und/oder in der Mikromechanik.

Zur Herstellung derartig dreidimensional strukturierter Oberflächenstrukturen wurden bisher verschiedene verfahren vorgeschlagen oder angewendet, z.B.:
a) Das Aufsputtern einer strukturierten Ätzmaske in Schattenwurftechnik und anschließendes Ätzen in einem Prozeß, der sowohl die Maske als auch das Material abträgt. Bei diesem Verfahren gibt es Schwierigkeiten hinsichtlich der Justiermöglichkeit und der Beeinflußbarkeit der Taperform.
b) Die mehrfache Wiederholung der Prozeßfolge "Lithographie und Ätzen". Dieses Verfahren kann z.B. für die Herstellung von Fresnel-Linsen oder integrierten Mikrolinsen verwendet werden, ist aber entweder sehr zeitintensiv oder erlaubt nur eine sehr grobe Dickenstufung. Außerdem treten Justierprobleme auf.
c) Das Ätzen mit einer Ätzmaske aus Photolack, der durch Hardbake vertikal verrundet wurde. Dieses Verfahren kann z.B. für die Herstellung von Mikrolinsen angewendet werden, bereitet aber Schwierigkeiten hinsichtlich der eingeschränkten Kontrolle der vertikalen Form, z.B. wegen Grenzwinkel an der Lackkante.

Der im Anspruch 1 angegebenen Erfindung liegt die Aufgabe zugrunde, ein besonders einfaches Verfahren der eingangs genannten Art anzugeben, mit dem beliebige reliefartige Oberflächenstrukturen kontrolliert und gut reproduzierbar hergestellt werden können.

Bevorzugte Ausgestaltungen dieses Verfahrens gehen aus den Ansprüchen 2 und 3 hervor.

Bevorzugte und vorteilhafte Verfahren zur Herstellung der bei dem erfindungsgemäßen Verfahren verwendeten Photolackschicht mit einer reliefartigen Oberflächenstruktur gehen aus den Ansprüchen 4 bis 8 hervor.

Vorteilhafte Anwendungen des erfindungsgemäßen Verfahrens zur Erzeugung einer reliefartigen Oberflächenstruktur auf der Oberfläche eines Substrats sind im Anspruch 9 angegeben.

Die Erfindung wird anhand der Figuren in der nachfolgenden Beschreibung beispielhaft näher erläutert. Es zeigen:
- Figuren 1a bis 1c: in schematischer Darstellung drei aufeinander folgende Belichtungsschritte zur Erzeugung der Belichtung der Photolackschicht gleichmäßiger Schichtdicke mit ortsabhängiger Belichtungsdosis,
- Figuren 2a und 2b: in zwei Diagrammen das Profil der bei den Schritten nach den Figuren 1a bis 1c erhaltenen ortsabhängigen Belichtungsdosis und das Profil der daraus resultierenden ortsabhängigen Schichtdicke des Photolacks nach der Entwicklung,
- Figur 3: in schematischer Seitenansicht die entwickelte Photolackschicht mit der entsprechend dem Profil nach Figur 2b strukturierten Oberfläche auf einem Substrat,
- Figur 4: in der Seitenansicht nach Figur 3 die nach Abtrag des Photolacks nach Figur 3 erhaltene stufenförmige Oberflächenstruktur auf dem Substrat, deren Profil dem Profil nach Figur 3 gleicht,
- Figur 5: im Maßstab das gemessene vielstufige Lackdickenprofil einer auf einem InP-Substrat erzeugten Photolackschicht aus gefärbtem Positiv-Photolack mit stufenartiger Oberflächenstruktur für einen optischen Schichtdicken-Taper, und
- Figur 6: im Maßstab das gemessene Profil der nach Abtrag der Photolackschicht nach Figur 5 mittels eines reaktiven Ionenstrahlverfahrens erhaltenen Oberflächenstruktur des InP-Substrats, die den Taper bildet.

Das erfindungsgemäße Verfahren zur Herstellung der reliefartigen Oberflächenstruktur auf dem Substrat setzt eine Photolackschicht mit einer reliefartigen Oberflächenstruktur, die im wesentlichen gleich der zu erzeugenden reliefartigen Oberflächenstruktur auf dem Substrat ist, voraus. Die Art der Herstellung einer derart strukturierten Photolackschicht ist für das eigentliche Verfahren zur Herstellung der reliefartigen Oberflächenstruktur auf dem Substrat prinzipiell nicht von Bedeutung. Jedes Verfahren, das zu einer derart strukturierten Photolackschicht führt, ist geeignet.

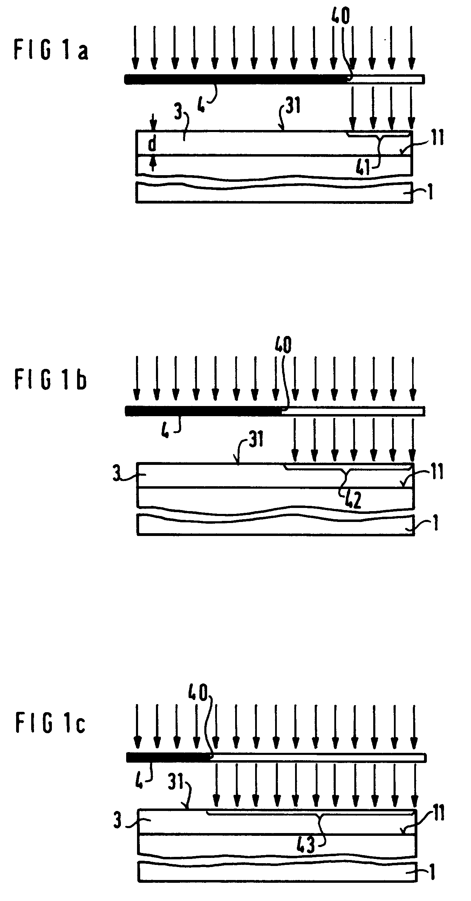

Ein besonders einfaches und vorteilhaftes Verfahren zur Herstellung einer derartigen Photolackschicht wird am Beispiel einer stufenförmigen Oberflächenstruktur, die zur Herstellung von optischen Schichtdicken-Tapern geeignet ist, unter Bezugnahme auf die Figuren 1a bis 1c erläutert.

Auf die Oberfläche 11 eines Substrats 1 wird eine Photolackschicht 3 gleichmäßiger Dicke d aufgebracht.

Die Oberfläche 31 der Photolackschiht 3 wird mit einer Belichtungsmaske 4 abgedeckt. Diese Belichtungsmaske 4 weist eine Öffnung 40 auf, durch die ein Belichtungsfeld 41 auf der Oberfläche 31 mit einer bestimmten Belichtungsdosis belichtet werden kann.

Für einen nächsten Belichtungsschritt wird eine Belichtungsmaske 4 mit einer größeren Öffnung 40 verwendet, durch die ein Belichtungsfeld 42 auf der Oberfläche 31, welches das Belichtungsfeld 41 überlagert, mit einer bestimmten Belichtungsdosis belichtet werden kann. Dies hat zur Folge, daß das im Belichtungsfeld 42 enthaltene Belichtungsfeld 41 doppelt und folglich mit einer höheren Dosis als der übrige Teil des Belichtungsfeldes 42 belichtet worden ist.

Bei einem nächsten Belichtungsschritt wird eine Maske 4 mit einer noch größeren Öffnung 40 verwendet, durch die ein Belichtungsfeld 43 auf der Oberfläche 31, das die beiden Belichtungsfelder 41 und 42 überlagert, mit einer bestimmten Belichtungsdosis belichtet werden kann. Dies hat zur Folge, daß das Belichtungsfeld 41, weil dreimal belichtet, mit der höchsten Belichtungsdosis belichtet worden ist. Der außerhalb des Belichtungsfeldes 41 liegende Bereich des Belichtungsfeldes 42 ist, weil nur zweimal belichtet, mit einer geringeren Belichtungsdoses belichtet worden. Der außerhalb des Belichtungsfeldes 42 liegende Bereich des Belichtungsfeldes 43 ist, weil nur einmal belichtet, mit einer noch geringeren Belichtungsdosis belichtet worden. Schließlich ist der außerhalb des Belichtungsfeldes 43 liegende Bereich der Oberfläche 31, da unter der Maske 4 liegend, nicht belichtet worden.

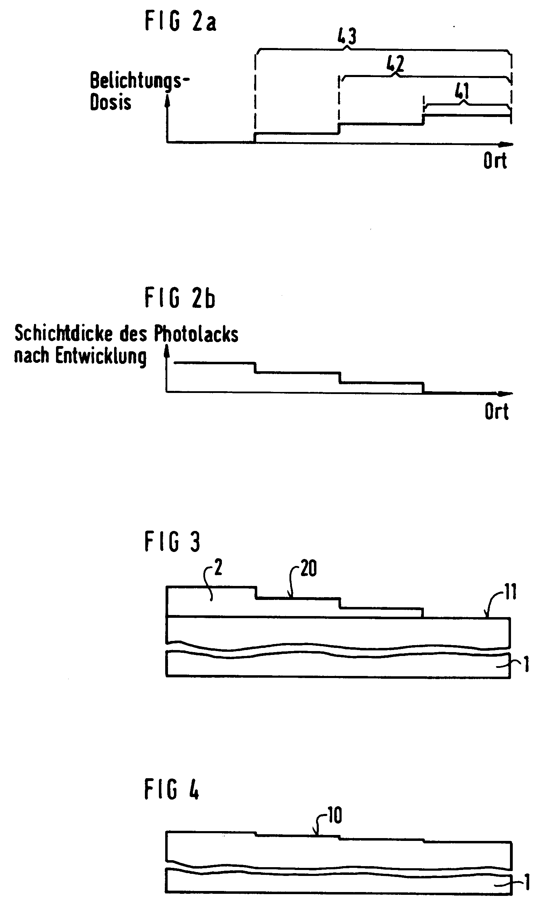

Das resultierende stufenförmige örtliche Profil der Belichtungsdosis ist in Figur 2a schematisch gezeigt.

Aus der derart belichteten Photolackschicht 3 entsteht nach der Entwicklung des Photolacks eine Photolackschicht 2 mit der stufenförmigne Oberflächenstruktur 20 nach Figur 3, wobei das Profil dieser Oberflächenstruktur 20 in der Figur 2b in Zusammenhang mit dem Profil der Belichtungsdosis nach Figur 2a gebracht ist. Danach ist der Photolack nach der Entwicklung in dem am stärksten belichteten Belichtungsfeld 41 vollständig abgetragen, während er im Bereich außerhalb des Belichtungsfeldes 43, in dem keine Belichtung stattfand, voll stehengeblieben ist. Dabei ist ein Positiv-Photolack vorausgesetzt. Bei Verwendung eines Negativ-Photolacks wären die Verhältnisse umgekehrt.

Die Belichtungsdosen für Belichtung der einzelnen Belichtungsfelder 41, 42 und 43 können gleich oder verschieden voneinander sein. Es kann auch so vorgegangen werden, daß beispielsweise nur eine Maske 4 mit einer Öffnung 40 verwendet wird, die nur das Belichtungsfeld 41 der Oberfläche 31 belichtet. Durch Verschieben dieser Maske kann neben dem belichteten Belichtungsfeld 41 erneut ein solches Belichtungsfeld 41 der Oberfläche 31 belichtet werden usw.. Sollen sich die Schichtdicken des entwickelten Photolacks bei verschiedenen solchen Belichtungsfeldern 41 voneinander unterscheiden, müssen für diese Belichtungsfelder 41 voneinander verschiedene Belichtungsdosen verwendet werden.

Zur Herstellung feinerer reliefartiger Oberflächenstrukturen müssen entsprechend kleine Belichtungsfelder, eine Vielzahl von Belichtungsschritten und ggf. fein aufeinander abgestimmte Belichtungsdosen verwendet werden. Als Begrenzung wirkt im wesentlichen die Stufenhöhe, die durch die meist gerätetechnisch bedingte Belichtungsdosis vorgegeben ist. Vorzugsweise wird für die Belichtung ein Waferstepper verwendet, da mit einem solchen Gerät die Mehrfachbelichtung sehr einfach auszuführen und präzise zu kontrollieren ist.

Zur Erzeugung kontinuierlicher reliefartiger Oberflächenstrukturen müssen Belichtungsmasken verwendet werden, deren Durchlässigkeit für die Belichtungsstrahlung kontinuierlich ortsabhängig ist.

Das Relief der Photolackschicht, insbesondere die Form des Dickenprofils des Photolacks kann weitgehend beliebig eingestellt werden.

Die Photolackschicht 2 mit der reliefartigen Oberflächenstruktur 20 wird mit einem Abtragverfahren, das sowohl den Photolack als auch vom Photolack freies und/oder während des Abtrags freiwerdendes Substratmaterial abträgt, entfernt. Nach dieser Entfernung ist die gewünschte reliefartige Oberflächenstruktur 10 nach Figur 4 entstanden. Daß die reliefartige Oberflächenstruktur im wesentlichen gleich der zu erzeugenden, vorgebenen reliefartigen Oberflächenstruktur ist, soll bedeuten, daß sich beide Strukturen insofern voneinander unterscheiden können, als bei dem Abtragverfahren der Photolack eine andere Abtragrate als das Substrat aufweisen kann. Ein solcher Unterschied muß bei der Oberflächenstruktur der Photolackschicht im voraus in der Stufenhöhe berücksichtigt werden.

Das Erreichen der gewünschten reliefartigen Oberflächenstruktur der Photolackschicht kann durch kontrollierte Entwicklung, beispielsweise durch in situ-Beobachtung des Lackabtrags während der Entwicklung mittels eines Interferometer-Aufbaus sichergestellt werden.

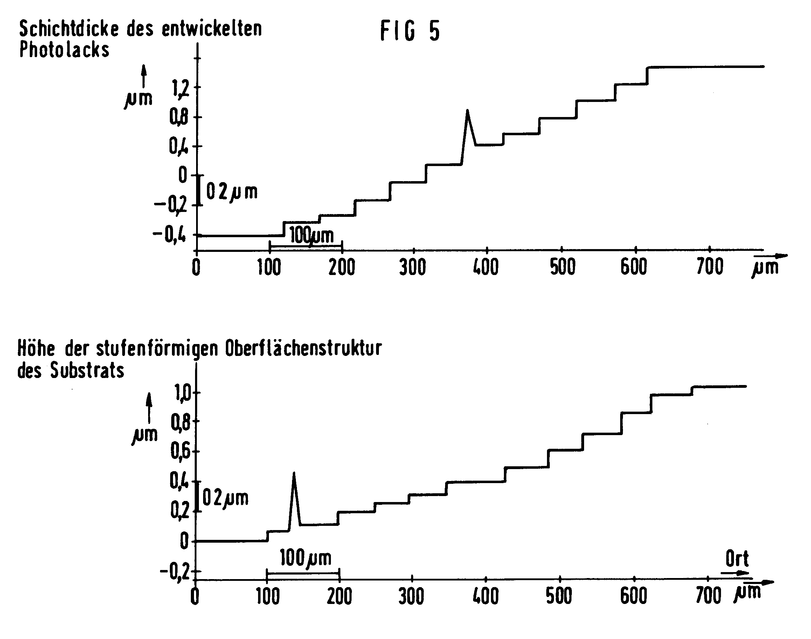

Mit dem vorstehend beschriebenen Verfahren wurde eine Lackschicht mit einem stufenartigen Schichtdicken-Taper realisiert. Die Belichtung erfolgte mittels eines Belichtungsgeräts in Form eines Wafersteppers in einem gefärbten Positiv-Photolack. Figur 5 zeigt das gemessene vielstufige Lackdickenprofil der entwickelten Photolackschicht. Diese Photolackschicht wurde mittels eines reaktiven Ionenstrahl-Ätzverfahrens (RIBE-Trockenätzung) unter Verwendung der Ätzgase N₂ und O₂ in das InP-Substrat übertragen, auf das die Photolackschicht aufgebracht wurde. Figur 6 zeigt das gemessene Oberflächenprofil dieses Substrats.

## Patentansprüche

1. Verfahren zur Erzeugung einer reliefartigen Oberflächenstruktur (10) auf der Oberfläche (11) eines Substrats (1),
**dadurch gekennzeichnet,**
daß auf der Oberfläche (11) des Substrats (1) eine Photolackschicht (2) mit einer reliefartigen Oberflächenstruktur (20), die im wesentlichen der zu erzeugenden reliefartigen Oberflächenstruktur (10) auf der Oberfläche (11) des Substrats (1) gleich ist, erzeugt, und mit einem Abtragverfahren, das sowohl den Photolack als auch vom Photolack freies und/oder freiwerdendes Substratmaterial abträgt, der Photolack entfernt wird.

2. Verfahren nach Anspruch 1,
**dadurch gekennzeichnet,**
daß der Photolack mit einem reaktiven Ionenstrahlverfahren abgeätzt wird.

3. Verfahren nach Anspruch 2,
**dadurch gekennzeichnet,**
daß beim reaktiven Ionenstrahlverfahren N₂ und als Ätzgas verwendet werden.

4. Verfahren zur Erzeugung einer Photolackschicht (2) mit einer reliefartigen Oberflächenstruktur (20), insbesondere für ein Verfahren nach einem der vorhergehenden Ansprüche,
**dadurch gekennzeichnet,**
daß eine Photolackschicht (3) gleichmäßiger Schichtdicke (d) mit örtlich verschiedenen Belichtungsdosen belichtet und nach der Belichtung entwickelt wird.

5. Verfahren nach Anspruch 4,
**dadurch gekennzeichnet,**
daß die Photolackschicht (3) gleichmäßiger Schichtdicke (d) in verschiedenen nebeneinanderliegenden Belichtungsfeldern (41) mit feldweise unterschiedlich oder auch gleich gewählten Belichtungsdosen belichtet wird.

6. Verfahren nach Anspruch 4 oder 5,
**dadurch gekennzeichnet,**
daß die Photolackschicht (3) gleichmäßiger Schichtdicke (d) in verschiedenen, teilweise überlagerten Belichtungsfeldern (41, 42, 43) mit feldweise gleich oder unterschiedlich gewählten Belichtungsdosen belichtet wird.

7. Verfahren nach einem der Ansprüche 4 bis 7,
**dadurch gekennzeichnet,**
daß ein Lackabtrag der belichteten Photolackschicht (3) gleichmäßiger Schichtdicke (d) während der Entwicklung dieser Schicht (3) beobachtet wird.

8. Anwendung eines Verfahrens nach einem der Ansprüche 1 bis 3 zur Herstellung eines wellenleitenden optischen Schichtdicken-Tapers auf einem Substrat, einer geodätischen Linse auf einem Substrat, einer integrierten Mikrolinse, einer Fresnel-Linse, eines geblazten optischen Gitters und/oder einer reliefartigen Oberflächenstruktur für die Mikromechanik.
